# EUROPÄISCHE PATENTSCHRIFT

(11) **EP 4 273 561 B1**
(45) Veröffentlichungstag und Bekanntmachung des Hinweises auf die Patenterteilung: **04.12.2024**
(21) Anmeldenummer: 23171119.3
(22) Anmeldetag: 02.05.2023
(51) Int. Cl.: G01R 11/04, H01R 13/11, H01R 9/24, G01R 1/04, H01R 4/34, H01R 11/05

(54) **ELEKTRISCHE FEDERKONTAKTKLEMME FÜR EINE ZÄHLERSTECKKLEMME**
ELECTRICAL SPRING CONTACT TERMINAL FOR A METER TERMINAL
BORNE ÉLECTRIQUE À RESSORT POUR BORNE ENFICHABLE DE COMPTEUR

(30) Priorität: 06.05.2022 CH 5292022
(43) Veröffentlichungstag der Anmeldung: 08.11.2023
(73) Patentinhaber: Eweco GmbH, 8330 Pfäffikon (CH)
(72) Erfinder: GREINER, Daniel, 8330 Pfäffikon (CH); MEISTER, Stephan, 8488 Turbenthal (CH)
(74) Vertreter: Rutz, Andrea

(56) Entgegenhaltungen:
- DE-A1- 102010 053 136
- US-B1- 7 048 591

## Beschreibung

### TECHNISCHES GEBIET

Die vorliegende Erfindung betrifft eine elektrische Federkontaktklemme für eine Zählersteckklemme, die zum Anschliessen eines Stromzählers an das elektrische Stromversorgungsnetz dient. Die Erfindung betrifft ausserdem eine Zählersteckklemme mit einer derartigen Federkontaktklemme.

### STAND DER TECHNIK

Zählersteckklemmen werden eingesetzt, um Stromzählerwechsel sehr rasch und ohne Strom- beziehungsweise Spannungsunterbruch gewährleisten zu können. Im Gegensatz zu Zähleranschlussklemmen, welche netzseitig und zählerseitig geschraubt werden, wird bei sogenannten Zählersteckklemmen üblicherweise nur die Netzseite bei der Initialinstallation geschraubt. Auf der Seite, welche den Stromzähler aufnimmt, besteht eine Steckverbindung. Steckverbindungen haben sich aufgrund von nachfolgend durchzuführenden Stromzählerwechseln aus Gründen des Arbeitsaufwandes und der Arbeitssicherheit als vorteilhaft erwiesen.

Bei Zähleranschlussklemmen bestehen die Nachteile, dass zählerseitig unter Spannung geschraubt werden muss, was somit einerseits eine erhöhte Gefahr bedeutet für den montierenden Arbeiter, und andererseits fehleranfällig ist, da das Festziehen der Schrauben vergessen werden kann. Beim versehentlichen Vergessen von dem Festziehen von Rahmenklemmen oder extrudierten Blöcken besteht die Gefahr einer sehr mangelhaften elektrischen Verbindung und somit die Gefahr eines sogenannten "Hot Spots", respektive Lichtbogens und im schlimmsten Falle entwickelt sich dies zu einer möglichen Brandursache.

Eine typische Zählersteckklemme weist auf einer Netzanschlussseite Klemmanschlusselemente für Stromkabel auf und auf einer der Netzanschlussseite meist gegenüberliegenden Zähleranschlussseite Klemmanschlusselemente für die Kontaktstifte des Stromzählers. Während die Stromkabel meist mittels Verschraubung mit der Zählersteckklemme verbunden werden, wird der Stromzähler mit seinen Kontaktstiften in entsprechend an der Zählersteckklemme vorgesehene Federkontakte eingeschoben. Die Federkontakte bilden somit die elektrische Verbindung zum Stromzähler.

Bei einem Austausch des Stromzählers wird auf die Zählersteckklemme eine Überbrückungsvorrichtung aufgesteckt, welche den Austausch des Zählers ohne eine Unterbrechung der Stromversorgung ermöglicht. Während des Austauschs fliesst "nicht gezählter" Strom durch den Überbrückungsstecker. Eine derartige Überbrückungsvorrichtung mit elektrischen Leiterbrücken für die Überbrückung des an das elektrische Stromnetz angeschlossenen Stromzählers bei einem Wechsel des Stromzählers ist insbesondere aus der Norm DIN VDE 0603-3-3:2020-08, Absatz 9.101, Bild 101, bekannt.

Zähleranschlussklemmen, bei welchen sowohl netz- als auch zählerseitig geschraubt werden muss, sind beispielsweise aus der DE 102 16 913 A1 und der CH 711 633 B1 bekannt.

Zählersteckklemmen, in welche der Stromzähler einfach einsteckbar ist, sind zum Beispiel in DE 101 63 620 B4, DE 2 256 373 A1 und DE 41 13 328 A offenbart. In den beiden letztgenannten Dokumenten weist die Zählersteckklemmen jeweils mehrteilig aufgebaute Federkontaktklemmen auf. Die Klemmwirkung wird mittels einer Spiralfeder erzeugt, die zwischen den beiden Schenkeln der Klemme angeordnet ist. Derartige Zählersteckklemmen haben gegenüber Zähleranschlussklemmen den Vorteil, dass nicht unter Spannung geschraubt werden muss und die Möglichkeiten für eine Fehlmanipulation deutlich geringer sind.

Weiterer relevanter Stand der Technik ist beispielsweise bekannt aus EP 1 586 908 A1, US 2017/0040715 A1, US 4,798,546, US 4,643,510, DE 203 15 898 U, DE 10 2015 013 011 A1, DE102010053136 A1, US7048591 B1 und EP 1 901 398 A1.

Bei vielen aktuell verfügbaren Zählersteckklemmen besteht der Nachteil, dass die Federkontakte so dimensioniert und gestaltet sind, dass die Stromstärke begrenzt ist, zum Beispiel auf 63 Ampère. Oft werden bei den bekannten Zählersteckklemmen tulpenförmige Federkontaktklemmen verwendet, um jeweils einen der Kontaktstifte des Stromzählers zu kontaktieren. Zwar können Federkontakte in Form von derartigen Kontakttulpen relativ einfach hergestellt werden. Die Verbindung für den Strom von der Kontakttulpe zur Rahmenklemme, welche zum Anschliessen der Anschluss Zählersteckklemme an das Stromversorgungsnetz dient, bildet dann aber oft das limitierende Bauteilelement, welches eine Verwendung der Zählersteckklemme für grössere Stromstärken verunmöglicht.

### DARSTELLUNG DER ERFINDUNG

Es ist eine Aufgabe der vorliegenden Erfindung, eine elektrische Federkontaktklemme für eine Zählersteckklemme zum Anschliessen eines Stromzählers an das elektrische Stromversorgungsnetz anzugeben, welche nicht nur kostengünstig herstellbar und funktional zuverlässig ist, sondern auch besonders gut für hohe Stromstärken geeignet ist.

Zur Lösung dieser Aufgabe wird eine elektrische Federkontaktklemme vorgeschlagen, wie sie in Anspruch 1 angegeben ist. Ausserdem wird in Anspruch 8 eine Zählersteckklemme mit einer derartigen Federkontaktklemme angegeben. Weitere Ausführungsformen sind in den abhängigen Ansprüchen angegeben.

Die vorliegende Erfindung stellt also eine elektrische Federkontaktklemme für eine Zählersteckklemme zur Verfügung, die zum Anschliessen eines Stromzählers an das elektrische Stromversorgungsnetz dient, die Federkontaktklemme aufweisend
eine Kontakttulpe mit einem ersten Klemmschenkel und einem zweiten Klemmschenkel, welche über einen Verbindungsabschnitt miteinander verbunden sind und zum beidseitigen Kontaktieren und Festklemmen eines Kontaktstiftes des Stromzählers dienen; sowie
eine einstückig mit der Kontakttulpe verbundene Kontaktlasche zur Herstellung eines Kontakts mit dem elektrischen Stromversorgungsnetz.

Die Federkontaktklemme weist ausserdem einen ersten Überführungsabschnitt auf, welcher den ersten Klemmschenkel beabstandet zum Verbindungsabschnitt elektrisch und mechanisch mit der Kontaktlasche verbindet, sowie einen zweiten Überführungsabschnitt, welcher den zweiten Klemmschenkel beabstandet zum Verbindungsabschnitt elektrisch und mechanisch mit der Kontaktlasche verbindet.

Aufgrund der beiden Überführungsabschnitte kann der Strom von den beiden Klemmschenkel jeweils separat zur Kontaktlasche geleitet werden. Durch die separate, d.h. zweifache Weiterleitung kann der zur Stromleitung zwischen Kontakttulpe und Kontaktlasche dienende Gesamtmaterialquerschnitt erheblich vergrössert und insbesondere auf die Auslegung von Kontakttulpe und Kontaktlasche abgestimmt werden. Die Verbindung zwischen Kontakttulpe und Kontaktlasche bildet dadurch in Bezug auf die Stromführung nicht das limitierende Bauteilelement. Die Federkontaktklemme kann somit aufgrund der beiden Überführungsabschnitte besonders gut und mit verhältnismässig geringem Materialaufwand auch für hohe Stromstärken ausgelegt werden. Bevorzugt ist die Federkontaktklemme für Nennströme bis 80 Ampère und Spitzenbelastungen bis 128 Ampère ausgelegt.

Bevorzugt dienen die Überführungsabschnitte nicht nur zur Verbesserung der Stromübertragung von der Kontakttulpe zur Kontaktlasche. Vorteilhaft dienen sie auch dazu, die Klemmkraft der Kontakttulpe zu beeinflussen und insbesondere einzustellen. Da die Überführungsabschnitte jeweils beabstandet zum Verbindungsabschnitt am Klemmschenkel angebracht sind, wird die Klemmkraft bzw. Federwirkung der Klemmschenkel durch die Überführungsabschnitte massgeblich mitbeeinflusst. Die Überführungsabschnitte können insbesondere und bevorzugt im Bereich der Kontaktlasche miteinander verbunden sein, um dadurch nicht nur die jeweils geführten Ströme zu vereinen, sondern auch um die Klemmkraft der Kontakttulpe zu definieren und diese vorzuspannen.

Die Kontakttulpe dient bevorzugt nicht nur zum beidseitigen Kontaktieren und Festklemmen eines Kontaktstiftes des Stromzählers, sondern auch zum beidseitigen Kontaktieren und Festklemmen eines Leiterelements einer Überbrückungsvorrichtung. Bevorzugt ist die Kontakttulpe dazu ausgebildet, dass ein Kontaktstift des Stromzählers aus einer ersten Richtung und ein Leiterelement der Überbrückungsvorrichtung aus einer dazu unterschiedlichen zweiten Richtung in die Kontakttulpe eingeschoben wird, wobei die erste und die zweite Richtung vorteilhaft rechtwinklig zueinander stehen. Insbesondere kann die Kontakttulpe dazu ausgebildet sein, dass bei bestimmungsgemässer Verwendung der Kontaktstift des Stromzählers in Längsrichtung, d.h. parallel dem Verbindungsabschnitt entlang, zwischen die beiden Klemmschenkel vorgeschoben wird, und dass das Leiterelement der Überbrückungsvorrichtung im Wesentlichen parallel zu den beiden Klemmschenkel zum Verbindungsabschnitt hin vorgeschoben wird. Durch das Vorschieben des Leiterelements der Überbrückungsvorrichtung in den Bereich zwischen den beiden Klemmschenkel, werden diese bevorzugt auseinander gedrückt und verringern dadurch die auf den Kontaktstift des Stromzählers ausgeübte Klemmkraft. Der Stromzähler kann dadurch nach Einschieben der Überbrückungsvorrichtung bequem aus der Federkontaktklemme herausgezogen werden. Die Stromleitung geht dabei nahtlos vom Stromzähler auf die Überbrückungsvorrichtung über und kann somit unterbruchsfrei gewährleistet werden. Der Stromzähler, bei welchem es sich auch um einen Smartmeter handeln kann, kann somit einfach und ohne Unterbrechung der Stromversorgung ausgetauscht werden.

Die Kontakttulpe mit ihren beiden über den Verbindungsabschnitt miteinander verbundenen Klemmschenkel weist insgesamt somit bevorzugt eine U-förmige Gestalt auf. Zur Einstellung einer optimalen Klemmkraft sind die beiden Schenkel dabei im unbelasteten Zustand bevorzugt etwas zueinander hin geneigt. An den zueinander hin gewandten Innenflächen der Klemmschenkel können Vertiefungen und/oder Rillungen ausgebildet sein, um die Festklemmung des Kontaktstifts des Stromzählers und/oder des Leiterelements der Überbrückungsvorrichtung zu verbessern.

Vorteilhaft weist die Kontakttulpe im nahe der freien Enden der beiden Klemmschenkel eine Einengung auf, um dann von dieser aus zu den freien Enden hin eine V-förmige Aufnahme zu bilden. Durch die Einengung kann die Klemmwirkung und Kontaktierung des vorteilhaft von oben her einzuschiebenden Leiterelements der Überbrückungsvorrichtung verbessert werden. Lokale, im Bereich der Einengung vorgesehene Erhebungen und/oder Vertiefungen, zum Beispiel in Form von Ausbuchtungen, können die Kontaktierung des Leiterelements weiter verbessern. Die V-förmig ausgebildete Aufnahme kann das Einschieben des Leiterelements erleichtern.

Die Kontaktlasche hat vorteilhaft eine rechteckige Form. Sie ist bevorzugt dazu ausgebildet, dass ein Kontaktelement des Stromversorgungsnetzes zwischen der Kontaktlasche und einem Festklemmelement, wie insbesondere einer Klemmschraube, festgeklemmt wird. Alternativ kann sie auch dazu ausgebildet sein, dass ein Festklemmelement, wie insbesondere eine Klemmschraube, direkt auf die Kontaktlasche wirkt, um ein Kontaktelement des Stromversorgungsnetzes zwischen der Kontaktlasche und einem anderen Gegenelement einzuklemmen.

Die Federkontaktklemme ist bevorzugt für eine Überbrückung mit einer genormten Überbrückungsvorrichtung ausgebildet, wobei die Norm der DIN VDE 0603-3-3:2020-08, Absatz 9.101, Bild 101 entspricht.

In einer insbesondere bevorzugten Ausführungsform erstrecken sich der erste Klemmschenkel und der zweite Klemmschenkel jeweils entlang einer Hauptrichtung vom Verbindungsabschnitt weg, welche rechtwinklig auf einer von der Kontaktlasche gebildeten Kontaktierungsfläche steht. Während sich die Klemmschenkel zum Beispiel im Wesentlichen in die vertikale Richtung vom Verbindungsabschnitt aus nach oben erstrecken, bildet die Kontaktlasche also bevorzugt eine Kontaktierungsfläche, die in einer horizontalen Ebene liegt. Dies hat den Vorteil, dass der Kontaktstift des Stromzählers und das Kontaktelement des Stromversorgungsnetzes dann bei der Montage von gegenüberliegenden Seiten her in die Federkontaktklemme eingeführt werden können, was sich in der Praxis insbesondere in Bezug auf den Platzbedarf als vorteilhaft erweist.

Bevorzugt ist die Federkontaktklemme als Ganzes einstückig ausgebildet. Die Federkontaktklemme kann dadurch nicht nur besonders einfach hergestellt werden, sondern gewährleistet auch eine jederzeit optimale Stromführung.

Die Kontaktlasche hat vorzugsweise im Vergleich zum ersten und zweiten Klemmschenkel eine doppelte so grosse Dicke. Der Materialquerschnitt der Kontaktlasche ist dadurch im Hinblick auf die Stromführung an die Kontakttulpe angepasst. Da die Kontaktlasche üblicherweise zur Anordnung und Festklemmung in einer Rahmenklemme ausgebildet ist, bewirkt eine doppelte so grosse Dicke der Kontaktlasche zudem auch einen erhöhten stromleitenden Querschnitt hin zu Rahmenklemme. Wenn die Federkontaktklemme als Ganzes aus einem Blech hergestellt ist (siehe weiter unten), kann eine solche doppelt so grosse Dicke der Kontaktlasche besonders einfach erreicht werden, indem bei der Herstellung der Federkontaktklemme einfach zwei Blechabschnitte aufeinandergelegt werden, die dann gemeinsam die Kontaktlasche bilden.

In einer insbesondere bevorzugten Ausführungsform ist die Federkontaktklemme als Ganzes aus einem Blech hergestellt. Die Herstellung der Federkontaktklemmen wird dadurch besonders einfach und kostengünstig. Besonders vorteilhaft ist es, wenn die wesentliche Form der Federkontaktklemme zudem mittels einfachem Ausstanzen, Zuschneiden, Abkanten und/oder Umbiegen eines ursprünglich flachen Bleches herstellbar ist.

Bevorzugt ist die Kontaktlasche mittels zwei übereinandergelegten Blechabschnitten doppelt ausgeführt. Besonders bevorzugt ist es, wenn jeder der Blechabschnitte mit jeweils einem der Überführungsabschnitte verbunden ist. In diesem Fall sind durch die Befestigung der beiden übereinandergelegten Blechabschnitte aneinander die Klemmcharakteristika der Kontakttulpe besonders gut und genau einstellbar. Als besonders vorteilhaft hat sich hierzu eine Ausführungsform erwiesen, bei welcher die beiden Blechabschnitte in einem Durchsetzfügepunkt miteinander verbunden sind. Der Durchsetzfügepunkt ist bevorzugt oval ausgebildet.

Die vorliegende Erfindung betrifft ausserdem eine Zählersteckklemme zum Anschliessen eines Stromzählers an das elektrische Stromversorgungsnetz, aufweisend zumindest eine Federkontaktklemme, welche gemäss den obigen Angaben ausgebildet ist. Bevorzugt weist die Zählersteckklemme nicht nur eine, sondern eine Mehrzahl an solchen Federkontaktklemmen auf. Besonders bevorzugt ist eine Ausführungsform mit genau 7 derartigen Federkontaktklemmen.

Zusätzlich zu den Federkontaktklemmen weist die Zählersteckklemme vorzugsweise eine gleich grosse Zahl oder, was bevorzugt ist, eine um 1 grössere Zahl, an Rahmenklemmen, insbesondere Stahlrahmenklemmen, auf. Während die Federkontaktklemmen die Anschlüsse an den Stromzähler bilden, bilden die Rahmenklemmen dann die Anschlüsse an das Stromversorgungsnetz. Die bevorzugt zusätzlich vorhandene Stahlrahmenklemme kann insbesondere zum Anschliessen eines zweiten Nullleiters dienen. Die Rahmenklemmen dienen bevorzugt zur Festklemmung und gegenseitigen Kontaktierung der Kontaktlasche und eines Kontaktelements des Stromversorgungsnetzes.

Die Zählersteckklemme weist in der Regel ein Gehäuse auf, in welchem die eine oder die mehreren Federkontaktklemmen untergebracht sind. Das Gehäuse weist bevorzugt Überbrückungsöffnungen auf, welche jeweils zum Einführen eines Leiterelements einer Überbrückungsvorrichtung dienen. Die Leiterelemente sind bevorzugt durch die Überbrückungsöffnungen hindurch in die Kontakttulpen der Federkontaktklemmen einschiebbar. Besonders vorteilhalft aus Sicherheitsgründen ist es, wenn die Überbrückungsöffnungen innerhalb einer am Gehäuse vorgesehenen Vertiefung angeordnet sind, welche ein Berühren der Leiterelemente der Überbrückungsvorrichtung von aussen her verunmöglicht, sobald die Leiterelemente die Federkontaktklemmen kontaktieren. Die Person, welche die Überbrückungsvorrichtung bedient, ist dadurch nicht der Gefahr ausgesetzt, eine Leiterbrücke, welche unter elektrischer Spannung steht, berühren zu können und somit verletzt werden zu können.

Eine besonders einfache Herstellung ist möglich, wenn das Gehäuse als Ganzes einstückig ausgebildet ist. Das Gehäuse kann insbesondere aus einem Kunststoff im Spritzgussverfahren hergestellt sein. Vorteilhaft weist das Gehäuse eine Gehäuseöffnung auf, welche beispielsweise bei der Herstellung zum Einbringen der Federkontaktklemmen in das Gehäuseinnere dienen kann. Die Gehäuseöffnung ist bevorzugt mittels einer Bodenplatte verschliessbar. Die Bodenplatte kann aus einem im Vergleich zum Gehäuse besonders gut wärmeleitenden Kunststoff hergestellt sein.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine perspektivische Explosionsansicht einer erfindungsgemässen Ausführungsform einer Zählersteckklemme inkl. den darin aufgenommenen Federkontaktklemmen mit dazu passender Überbrückungsvorrichtung;
- Fig. 2: eine perspektivische Ansicht der Zählersteckklemme der Fig. 1 in Richtung der Zähleranschlussseite;
- Fig. 3: eine perspektivische Ansicht der Zählersteckklemme der Fig. 1 in Richtung der Netzanschlussseite;
- Fig. 4: eine Draufsicht auf die Netzanschlussseite der Zählersteckklemme der Fig. 1;
- Fig. 5: eine Draufsicht auf die Zähleranschlussseite der Zählersteckklemme der Fig. 1;
- Fig. 6: eine Draufsicht auf die Unterseite der Zählersteckklemme der Fig. 1;
- Fig. 7: eine Draufsicht auf die Oberseite der Zählersteckklemme der Fig. 1;
- Fig. 8: eine Schnittansicht der Zählersteckklemme der Fig. 1 durch die in der Figur 7 dargestellte Schnittebene VIII-VIII;
- Fig. 9: eine Schnittansicht der Zählersteckklemme der Fig. 1 durch die in der Figur 7 dargestellte Schnittebene IX-IX;
- Fig. 10: eine Schnittansicht der Zählersteckklemme der Fig. 1 durch die in der Figur 7 dargestellte Schnittebene X-X;
- Fig. 11: eine Schnittansicht der Zählersteckklemme und der Überbrückungsvorrichtung der Fig. 1 durch die in der Figur 12 dargestellte Schnittebene XI-XI;
- Fig. 12: eine Draufsicht auf die Oberseite der Zählersteckklemme und der darüber angeordneten Überbrückungsvorrichtung der Fig. 1;
- Fig. 13: eine perspektivische Ansicht einer einzelnen Federkontaktklemme der Zählersteckklemme der Fig. 1;
- Fig. 14: eine Draufsicht auf die Zähleranschlussseite der Federkontaktklemme der Fig. 13;
- Fig. 15: eine Draufsicht auf die Netzanschlussseite der Federkontaktklemme der Fig. 13;
- Fig. 16: eine Seitenansicht der Federkontaktklemme der Fig. 13;
- Fig. 17: eine Draufsicht auf die Oberseite der Federkontaktklemme der Fig. 13; sowie
- Fig. 18: eine Draufsicht auf die Unterseite der Federkontaktklemme der Fig. 13.

### BESCHREIBUNG BEVORZUGTER AUSFÜHRUNGSFORMEN

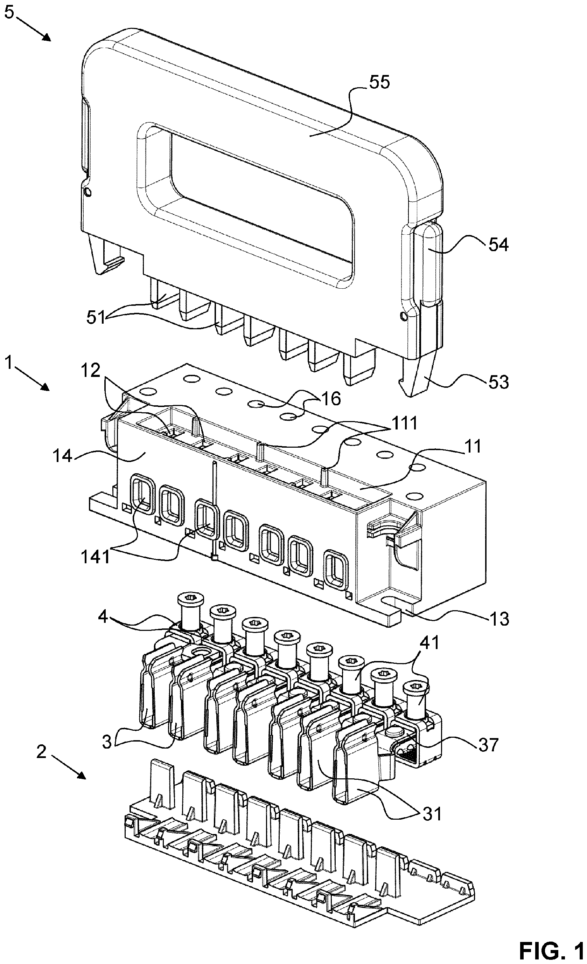

In den Figuren 1 bis 18 ist in verschiedenen Ansichten eine erfindungsgemässe Ausführungsform einer Zählersteckklemme inkl. den darin aufgenommenen Federkontaktklemmen 3 und einer dazu passenden Überbrückungsvorrichtung 5 gezeigt.

Die Figur 1 zeigt die offene Zählersteckklemme mit dem Gehäuse 1, der Bodenplatte 2 sowie den darin angeordneten Federkontaktklemmen 3 und Stahlrahmenklemmen 4.

Im Innern des Gehäuses 1 befinden sich 7 elektrische Federkontaktklemmen 3, welche jeweils eine Kontakttulpe 31 aufweisen, die einerseits zur Aufnahme einer Überbrückungsvorrichtung 5 und andererseits zur Aufnahme eines Kontaktstiftes des Stromzählers dient. Der Stromzähler ist in den Figuren nicht gezeigt. Dem Fachmann sind Stromzähler und deren Ausgestaltung aber hinlänglich bekannt. Die Federkontaktklemmen 3 sind derart im Gehäuse 1 angeordnet, dass ihre Kontakttulpen 31 jeweils von einer Zähleranschlussseite 14 des Gehäuse 1 her für den Stromzähler zugänglich sind. Das Gehäuse 1 weist hierzu entsprechende zählerseitige Anschlussöffnungen 141 auf, durch welche hindurch jeweils ein Kontaktelement des Stromzählers bis in eine Kontakttulpe 31 hinein vorschiebbar ist.

Die zählerseitigen Anschlussöffnungen 141 werden jeweils durch eine hier rechteckige, angefaste Öffnung gebildet und sind dadurch jeweils zur Aufnahme eines Zählerkontaktstiftes mit quadratischem und rundem Querschnitt ausgebildet. Die Fasen dienen dem Versatz, respektive Positionsfehlerausgleich der am Stromzähler montierten Kontaktstiften.

Zugewandt zu einer Netzanschlussseite 15 des Gehäuses 1 sind die Stahlrahmenklemmen 4 im Inneren des Gehäuses 1 angeordnet. Jede Stahlrahmenklemme 4 weist eine Klemmschraube 41 auf. Insgesamt sind 8 Stahlrahmenklemmen 4 vorgesehen, wobei sechs der Stahlrahmenklemmen für die drei Phasen dienen, also jeweils zwei für die Zu- und Ableitung des Stromes zum Stromzähler. Zwei der Stahlrahmenklemmen 4 dienen für den Nullleiteranschluss. Auf der vom Stromversorgungsnetz abgewandten Seite kontaktieren die Stahlrahmenklemmen 4 jeweils eine einstückig mit der Kontakttulpe 31 verbundene Kontaktlasche 37 einer jeweiligen Federkontaktklemme 3. Die Stahlrahmenklemmen 4 bilden dadurch eine elektrische Verbindung zwischen den Stahlrahmenklemmen 4 und dem Stromversorgungsnetz.

Die Überbrückungsvorrichtung 5 weist drei elektrische Leiterbrücken 51 auf, welche jeweils zwei parallel zueinander angeordnete Steckelemente haben, die zur Überbrückung jeweils von oben her in eine Kontakttulpe 31 einschiebbar sind. Die Steckelemente der Leiterbrücken 51 bilden somit Leiterelemente, mit welchen die Stromphasen überbrück- bzw. kurzschliessbar sind, d.h. jeder der Leiterbrücken 51 dient zur Zu- bzw. Ableitung von jeweils einer Phase. Des Weiteren weist die Überbrückungsvorrichtung 5 ein einzelnes vorstehendes Nullleitersteckelement 52 für den Nullleiter auf, welcher nicht überbrückt werden muss. Es bestehen aber zwei Abgänge des Nullleiters netzseitig. Ausserdem haben die vorstehenden Steckelemente der Leiterbrücken 51 die Funktion, die Kontakttulpen 31 zu öffnen, damit der Stromzähler mit seinen 7 Kontaktstiften (2 pro Phase sowie ein Nullleiter) einfach ausgewechselt werden kann. Während des Zählerwechsels fliesst der Strom über die Leiterbrücken 51 und nicht über den Stromzähler.

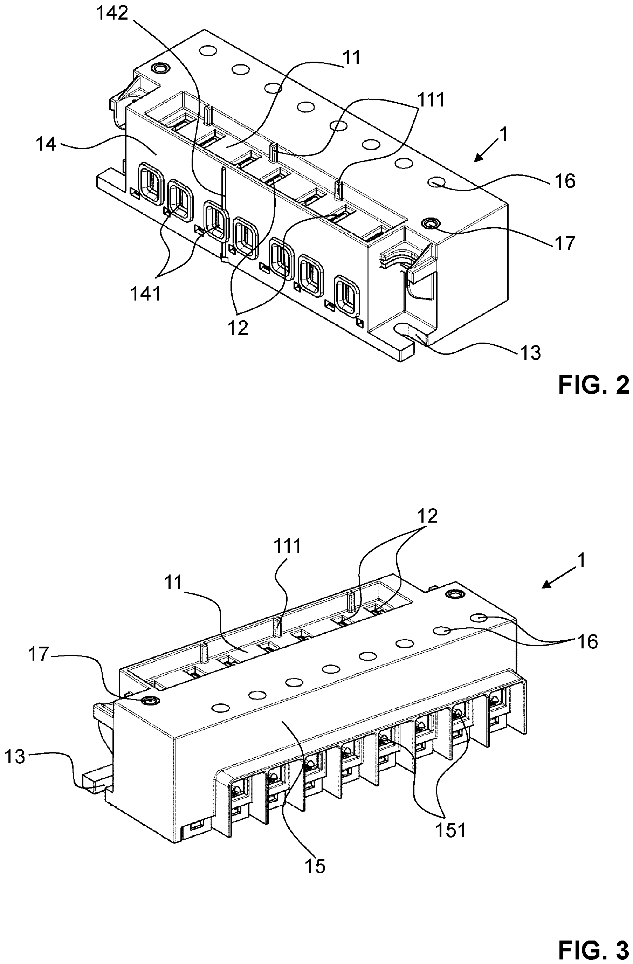

Wie in der Figur 1, aber auch in den Figuren 2 und 3 gut erkennbar ist, sind an der Oberseite des Gehäuses 1 Überbrückungsöffnungen 12 vorgesehen, welche zum Einführen der Überbrückungsvorrichtung 5 mit ihren Leiterbrücken 51 und ihrem Nullleitersteckelement 52 in die Kontakttulpen 31 hinein dienen. Die Überbrückungsöffnungen 12 sind innerhalb einer an der Gehäuseoberseite vorgesehenen Vertiefung 11 angeordnet. Die Vertiefung 11 bildet gemeinsam mit den Überbrückungsöffnungen 12 die Schnittstelle der Zählersteckklemme zur Überbrückungsvorrichtung 5. Die Vertiefung 11 der Schnittstelle bringt den Vorteil mit sich, dass beim Einstecken der Überbrückungsvorrichtung 5 in die Zählersteckklemme ein Berührungsschutz besteht. Die Vertiefung 11 ist hierzu derart ausgebildet, dass die Leiterbrücken 51 beim Einstecken von aussen her von einem Körperteil eines Menschen nicht mehr zugänglich sind, sobald sie mit den Kontakttulpen 32 in Kontakt geraten und dadurch potentiell stromführend sind. Bevorzugt ist die Vertiefung 11 sogar derart ausgebildet, dass die Leiterbrücken 51 bereits nicht mehr von aussen her zugänglich sind, bevor sie mit den Kontakttulpen 32 in Kontakt geraten. Eine Berührung von spannungsführenden Teilen mit einem Körperteil des Bedieners kann somit formgebunden ausgeschlossen werden und ist somit unmöglich.

Wie in den Figuren 1-3 ersichtlich können im Bereich der Vertiefung 11 Nocken 111 vorgesehen sein, um nur zugelassene und richtig dimensionierte Überbrückungsvorrichtungen 5 zuzulassen und nicht geeignete auszuschliessen. Die Handhabung der Überbrückungsvorrichtung 5 wird mittels eines Handgriffes 55 erleichtert.

Um die Überbrückungsvorrichtung 5 nach dem Einstecken an der Zählersteckklemme zu sichern, ist eine Rastverriegelung vorgesehen. Die Überbrückungsvorrichtung 5 weist hierzu vorstehende Rasthaken 53 auf, welche beim Einstecken zum Einhaken am Gehäuse 1 ausgebildet sind. Die Rastverriegelung kann mittels seitlich an der Überbrückungsvorrichtung 5 angeordneten Drucktasten 54 gelöst werden. Durch das Eindrücken der Drucktasten 54 werden die Rasthaken 53 vom Gehäuse 1 weg nach aussen geschwenkt.

Wie in den Figuren 2 und 3 erkennbar ist, sind an der Gehäuseoberseite Einpressmuttern 17 vorgesehen, die zur Befestigung von Abdeckhauben dienen, welche die Zählersteckklemme selbst schützen, solange kein Stromzähler mit entsprechender Abdeckung montiert ist. Ausserdem bieten die Abdeckungen einen Berührungsschutz, solange kein Stromzähler mit Zählerabdeckung montiert ist.

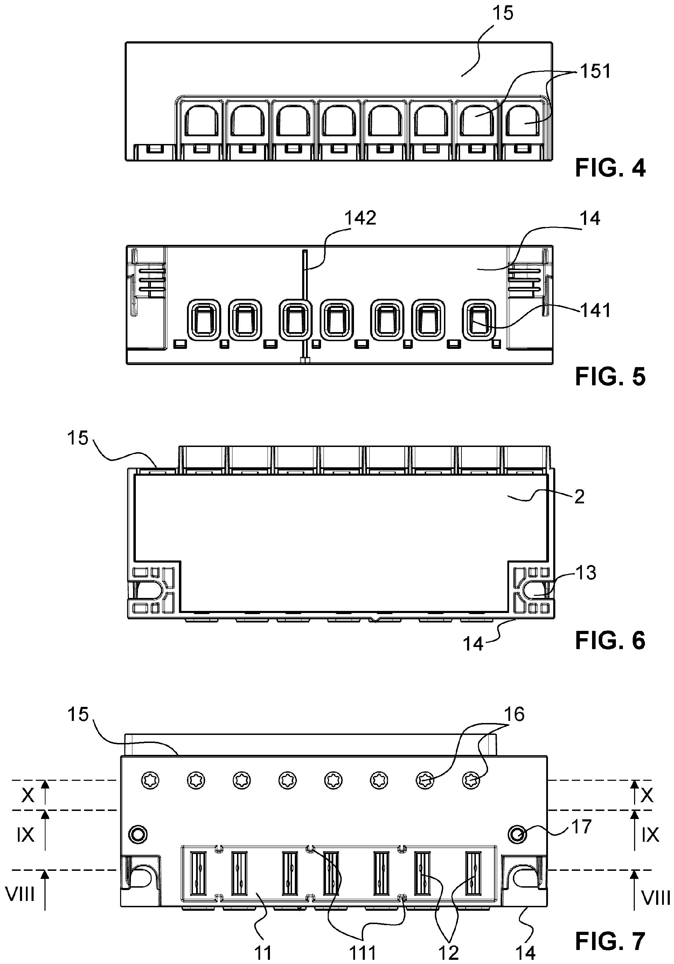

Auf der in den Figuren 3 und 4 gut erkennbaren Netzanschlussseite 15 sind am Gehäuse 1 netzseitige Anschlussöffnungen 151 ausgebildet, welche den Zugang zu den Stahlrahmenklemmen 4 ermöglichen, um die Zählersteckklemme mit dem Stromversorgungsnetz zu verbinden. Um einen Berührungsschutz zu bilden, sind die netzseitigen Anschlussöffnungen 151 vertieft am Gehäuse 1 vorgesehen. Um die einzelnen Verbindungen zwischen der Zählersteckklemme und dem Stromversorgungsnetz festzuziehen bzw. zu lösen, sind Zugänge zu den Klemmschrauben 41 in Form von Schrauböffnungen 16 vorgesehen. Die Schrauböffnungen 16 sind an der Oberseite des Gehäuses 1 angeordnet.

Die Befestigung der Zählersteckklemme z.B. an einer Hauswand kann mittels Verschraubungen erfolgen. Hierzu weist das Gehäuse 1 zwei Aussparungen 13 auf.

Wie in den Figuren 2 und 5 erkennbar ist, ist im Bereich der Zähleranschlussseite 14 eine Rippe 142 vorhanden, welche die Mittelstellung des Stromzählers markiert und eine Montagehilfe bildet.

Die Figur 6 zeigt die Zählersteckklemme von unten, das heisst als Draufsicht auf die mit der Bodenplatte 2 verschlossene Seite. Gut erkennbar sind hier insbesondere auch die am Gehäuse 1 vorgesehenen Aussparungen 13, welcher zur Montage der Zählersteckklemme dienen.

Die Figur 7 zeigt die Oberseite der Zählersteckklemme mit den Schrauböffnungen 16, der Vertiefung 11 und der innerhalb der Vertiefung 11 angeordneten Überbrückungsöffnungen.

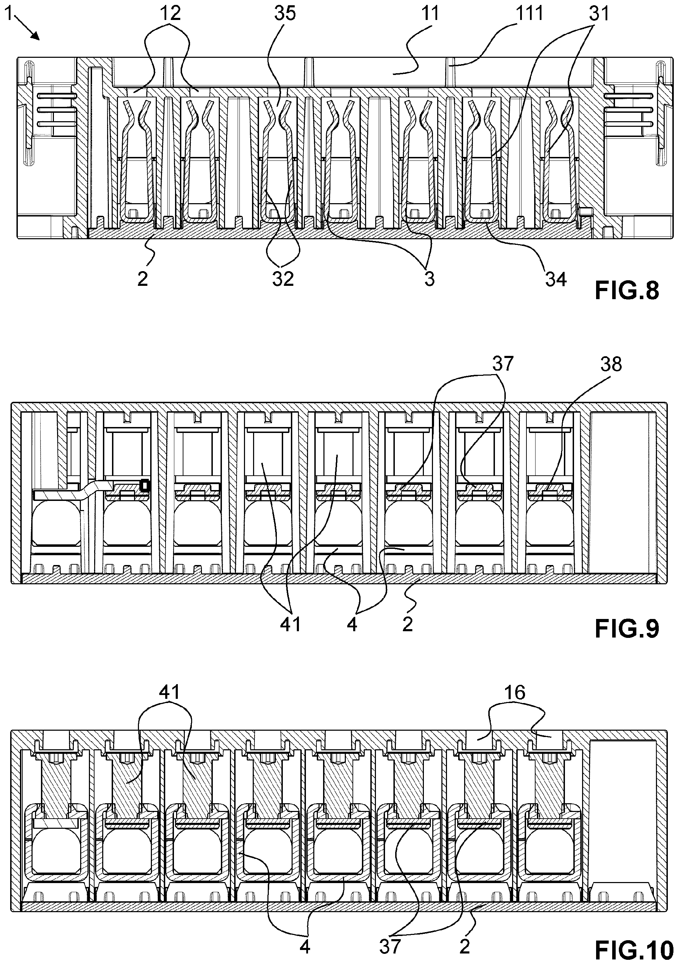

In der Schnittansicht der Figur 8 ist unter anderem ersichtlich, wie die Federkontaktklemmen 3 mit ihren Kontakttulpen 31 parallel zueinander in separaten Innenkammern des Gehäuses 1 angeordnet sind. Jede Innenkammer dient zur Aufnahme von jeweils einer Federkontaktklemme 3 und einer Stahlrahmenklemme 4.

Die Kontakttulpen 31 werden durch jeweils zwei Klemmschenkel 32 und einen Verbindungsabschnitt 34 gebildet. Die beiden Klemmschenkel 32 sind dabei mit einem Ende jeweils einstückig mit dem Verbindungsabschnitt 35 verbunden und erstrecken sich von diesem aus im Wesentlichen parallel zueinander entlang einer Haupterstreckungsrichtung nach oben hin. Die Kontakttulpen 31 weisen dadurch eine U-förmige Gestalt auf. Im oberen Bereich ihrer freien Enden weisen die Kontakttulpen 21 jeweils eine Einengung auf, welche zur Kontaktierung der von oben her einzuschiebenden Leiterelemente der Überbrückungsvorrichtung dienen. Von der Einengung aus bilden die Kontakttulpen 31 nach oben zu den freien Enden der Klemmschenkel 32 hin jeweils eine V-förmige Aufnahme 35, welche das Einführen der Leiterelemente der Überbrückungsvorrichtung vereinfachen. Jede Aufnahme 35 ist jeweils unmittelbar unterhalb einer der Überbrückungsöffnungen 12 angeordnet.

In den Schnittansichten der Figuren 9 und 10 ist insbesondere erkennbar, dass die Kontaktlaschen 37 der Federkontaktklemmen 3 jeweils mittels zwei übereinandergelegten Blechabschnitten doppelt ausgeführt sind. Die Figur 9 zeigt zudem Durchsetzfügepunkte 38, welche jeweils zur mechanischen und elektrischen Verbindung der beiden Blechabschnitte dienen. In der Figur 10 ist ausserdem erkennbar, dass die Stahlrahmenklemmen 4 jeweils einen Klemmkäfig bilden, in welchem ein Kontaktelement des Stromversorgungsnetzes derart mittels der Klemmschraube 41 festklemmbar ist, dass es sowohl von der Kontaktlasche 37 als auch von einem Teil der Stahlrahmenklemme 4 kontaktiert wird. Im Bereich von jeder Klemmschraube 41 ist am Gehäuse 1 jeweils ein runder Kragen angespritzt, welcher die Klemmschraube 41 am Schraubenkopf in Position hält. An den Schraubenenden ist jeweils ein zylindrischer Zapfen ausgebildet, welcher die Klemmschraube 41 an ihrem unteren Ende in Position hält. Auch wenn die Klemmschrauben 41 komplett aus dem Klemmkäfig ausgeschraubt werden, verhindern der Kragen und der zylindrische Zapfen am Schraubenende ein Verlassen der Schraube der nötigen Position, respektive der Mittelachse. Die Schrauben verbleiben also in Position und schrauben sich bei gegenläufiger Drehung wieder in den Klemmkäfig.

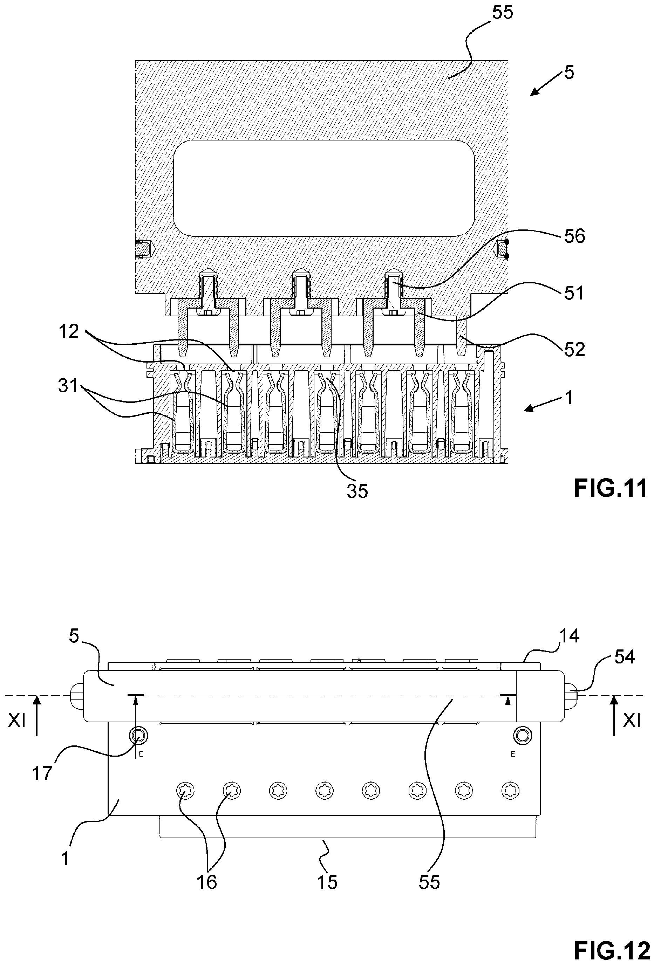

Die Figur 11 zeigt einen Schnitt in der in Figur 12 angezeigten Ebene XI-XI durch die Kontakttulpen 31 und durch eine Überbrückungsvorrichtung 5. Zu sehen sind die drei U-förmigen Leiterbrücken 51 für die drei Phasen, sowie das vorstehende Nullleitersteckelement 52. Das Nullleitersteckelement 52 ist nicht leitend ausgebildet, da es keine stromführende Funktion hat, sondern nur die Funktion der Öffnung der Kontakttulpe 31 erfüllt, um dadurch den Austausch des Stromzählers zu erleichtern. Die Leiterbrücken 51 sind jeweils mittels einer Befestigungsschraube 56 an dem bevorzugt aus einem nicht leitenden Kunststoffmaterial hergestellten Teil der Überbrückungsvorrichtung 5 angeschraubt, welcher auch den Handgriff 55 bildet.

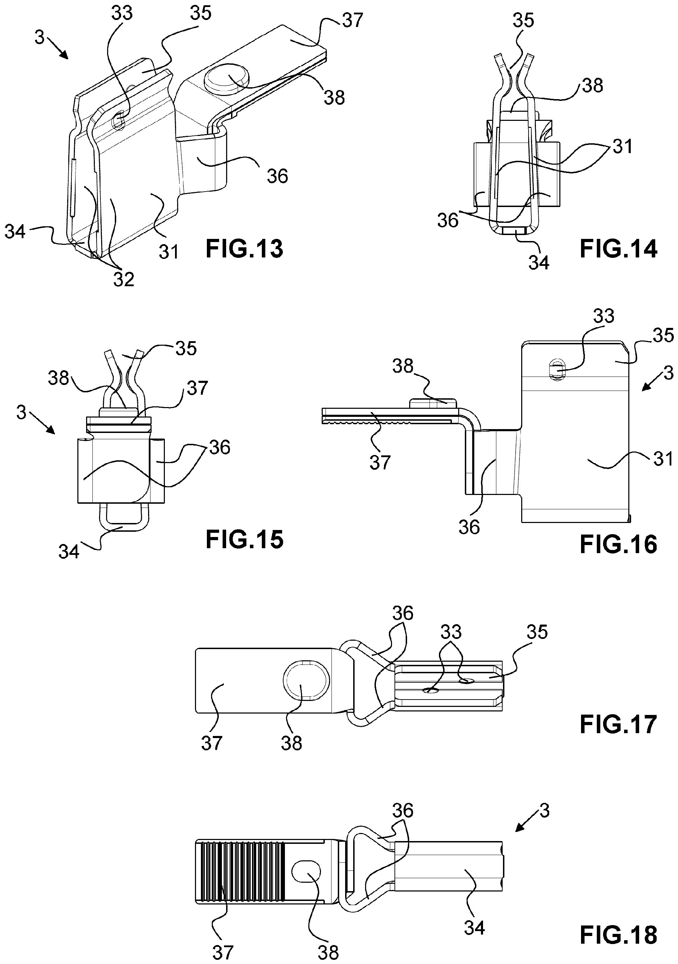

Die Figuren 13 - 18 zeigen in unterschiedlichen Ansichten jeweils eine Federkontaktklemme 3 in Alleinstellung. Aus diesen Figuren ist erkennbar, dass die Federkontaktklemme 3 als Ganzes aus einem zusammenhängenden, d.h. einstückigen, Blech hergestellt ist. Die Federkontaktklemme 3 kann insbesondere mittels Umbiegen eines vorgeformten, aber flachen Bleches hergestellt werden. Da dabei im Bereich der Kontaktlasche 37 zwei Blechabschnitte übereinandergelegt werden, wird deren Dicke doppelt so gross wie diejenige der Klemmschenkel 32. Die Kontaktlasche weist dadurch einen im Hinblick auf die Stromführung optimalen Materialquerschnitt auf.

Die mechanische und elektrische Verbindung der Kontakttulpe 13 zur Kontaktlasche 37 erfolgt via zwei Überführungsabschnitte 36. Dabei ist jeder Klemmschenkel 32 jeweils einstückig mit einem Überführungsabschnitt 36 verbunden. Der Strom wird dadurch separat von den beiden Klemmschenkeln 32 zur Kontaktlasche bzw. in die umgekehrte Richtung geleitet. Während einer der Überführungsabschnitte 36 in den unteren Blechabschnitt der Kontaktlasche 37 übergeht, geht der andere Überführungsabschnitt 36 in den oberen Blechabschnitt der Kontaktlasche 37 über. Die Kontaktlasche 37 erstreckt sich in einer Ebene, die sich parallel zur derjenigen des Verbindungsabschnitts 34 erstreckt, aber rechtwinklig zur Ebene steht, entlang welcher sich die Klemmschenkel 32 in Hauptrichtung vom Verbindungsabschnitt 34 nach oben hin weg erstrecken.

Wie in den Figuren 13 und 16 erkennbar ist, weist die Kontakttulpe 31 im Bereich ihrer oberen Einengung beidseits lokal geprägte Ausbuchtungen 33 auf, die zur Verbesserung des elektrischen Kontakts mit den Leiterbrücken 51 der Überbrückungsvorrichtung dienen. Um die Festklemmung des Kontaktelements des Stromversorgungsnetzes zu verbessern, ist die Unterseite der Kontaktlasche 37 gerillt ausgebildet, wie in der Figur 18 gut erkennbar ist.

Die Kontakttulpe 31 bildet somit eine Feder, welche mittels Einschieben von oben her der Leiterbrücken 51 bzw. des Nullleitersteckelements 52 geöffnet werden können. Durch das Öffnen des Kontakttulpe 31 wird das Herausziehen bzw. Einführen eines Zählerstiftes des Stromzählers von vorne her, d.h. in eine parallel zum Verbindungsabschnitt 34 verlaufende Richtung, erleichtert. Eingangsseitig an der Vorderseite der Kontakttulpe 51 sind auf ca. halber Höhe der Kontakttulpe 51 zwei 45°-Phasen zur Verbesserung der Aufnahme der Kontaktstifte ausgebildet (siehe Figuren 13 und 14).

Die Kontaktlasche 37 weist einen ovalen Durchsetzfügepunkt 38 auf, welcher die zwei Blechabschnitte in optimaler Federposition zusammenhält und insbesondere ein gutes Verhalten der Federkontaktklemme 3 bezüglich elektrischer und mechanischer Eigenschaften gewährleistet. Aufgrund der jeweils beabstandeten Verbindung der Überführungsabschnitte 36 mit den Klemmschenkeln 32 in Kombination mit der Befestigung der beiden Blechabschnitte im Durchsetzfügepunkt 38 kann eine genau eingestellte und gleichmässige Federkraft der Kontakttulpe 31 bei darin eingeschobenem Zählerkontaktstift erreicht werden. Es wird dadurch ein optimales Anliegen der Kontakttulpe 31 an den Zählerstift erreicht, wodurch eine effiziente und verlustarme elektrische Verbindung zum Stromzähler ermöglicht wird. Der ovale Durchsetzfügepunkt 38 wird bevorzugt gemäss dem unter dem Namen OVAL-LOC^{®} bekannten Verfahren der Firma BTM (Europe) Blechverbindungstechnik GmbH hergestellt. Der Durchsetzfügepunkt 38 dient insbesondere dazu, die ideale Lageposition der Kontakttulpe 31 beim Einsatz, also angeschlossen an das Stromnetz sowie über Kontaktstifte an den Stromzähler, sicherzustellen. Der ovale Durchsetzfügepunkt 38 gewährleistet zudem die korrekte Position der Kontaktlasche 37, welche die Verbindung zur Stahlrahmenklemme 4 gewährleistet. Der Durchsetzfügepunkt 38 gewährleistet somit höchste Effizienz und Klemmkraft in der elektrischen Verbindung.

### BEZUGSZEICHENLISTE

| | | | |
|---|---|---|---|
| 1 | Gehäuse | 32 | Klemmschenkel |
| 11 | Vertiefung | 33 | Ausbuchtung |
| 111 | Nocken | 34 | Verbindungsabschnitt |
| 12 | Überbrückungsöffnungen | 35 | Aufnahme |
| 13 | Aussparung | 36 | Überführungsabschnitt |
| 14 | Zähleranschlussseite | 37 | Kontaktlasche |
| 141 | Zählerseitige Anschlussöffnungen | 38 | Durchsetzfügepunkt |
| 142 | Rippe | 4 | Stahlrahmenklemmen |
| 15 | Netzanschlussseite | 41 | Klemmschraube |
| 151 | Netzseitige Anschlussöffnungen | 5 | Überbrückungsvorrichtung |
| 16 | Schrauböffnungen | 51 | Leiterbrücken |
| 17 | Einpressmutter | 52 | Nullleitersteckelement |
| | | 53 | Rasthaken |
| 2 | Bodenplatte | 54 | Drucktaste |
| | | 55 | Handgriff |
| 3 | Federkontaktklemme | 56 | Befestigungsschraube |
| 31 | Kontakttulpe | | |

## Patentansprüche

1. Elektrische Federkontaktklemme (3) für eine Zählersteckklemme, die zum Anschliessen eines Stromzählers an das elektrische Stromversorgungsnetz dient, die Federkontaktklemme (3) aufweisend
eine Kontakttulpe (31) mit einem ersten Klemmschenkel (32) und einem zweiten Klemmschenkel (32), welche über einen Verbindungsabschnitt (34) miteinander verbunden sind und zum beidseitigen Kontaktieren und Festklemmen eines Kontaktstiftes des Stromzählers dienen; sowie
eine einstückig mit der Kontakttulpe (31) verbundene Kontaktlasche (37) zur Herstellung eines Kontakts mit dem elektrischen Stromversorgungsnetz;
wobei
die Federkontaktklemme (3) ausserdem einen ersten Überführungsabschnitt (36) aufweist, welcher den ersten Klemmschenkel (32) beabstandet zum Verbindungsabschnitt (34) elektrisch und mechanisch mit der Kontaktlasche (37) verbindet, **dadurch gekennzeichnet, dass** die Federkontaktklemme (3) einen zweiten Überführungsabschnitt (36) aufweist, welcher den zweiten Klemmschenkel (32) beabstandet zum Verbindungsabschnitt (34) elektrisch und mechanisch mit der Kontaktlasche (37) verbindet.

2. Federkontaktklemme (3) nach Anspruch 1, wobei sich der erste Klemmschenkel (32) und der zweite Klemmschenkel (32) jeweils entlang einer Hauptrichtung vom Verbindungsabschnitt (34) weg erstrecken, welche rechtwinklig auf einer von der Kontaktlasche (37) gebildeten Kontaktierungsfläche steht.

3. Federkontaktklemme (3) nach Anspruch 1 oder 2, wobei die Federkontaktklemme (3) als Ganzes einstückig ausgebildet ist.

4. Federkontaktklemme (3) nach einem der vorhergehenden Ansprüche, wobei die Kontaktlasche (37) im Vergleich zum ersten und zweiten Klemmschenkel (32) eine doppelte so grosse Dicke hat.

5. Federkontaktklemme (3) nach einem der vorhergehenden Ansprüche, wobei die Federkontaktklemme (3) als Ganzes aus einem Blech hergestellt ist.

6. Federkontaktklemme (3) nach einem der vorhergehenden Ansprüche, wobei die Kontaktlasche (37) mittels zwei übereinandergelegten Blechabschnitten doppelt ausgeführt ist.

7. Federkontaktklemme (3) nach Anspruch 6, wobei die beiden Blechabschnitte in einem insbesondere ovalen Durchsetzfügepunkt (38) miteinander verbunden sind.

8. Zählersteckklemme zum Anschliessen eines Stromzählers an das elektrische Stromversorgungsnetz, aufweisend zumindest eine Federkontaktklemme (3) nach einem der vorhergehenden Ansprüchen.

9. Zählersteckklemme nach Anspruch 8, aufweisend ein Gehäuse (1) mit Überbrückungsöffnungen (12), welche jeweils zum Einführen eines Leiterelements (51) einer Überbrückungsvorrichtung (5) dienen, wobei die Überbrückungsöffnungen (12) innerhalb einer am Gehäuse (1) vorgesehenen Vertiefung (11) angeordnet sind, welche ein Berühren der Leiterelemente (51) der Überbrückungsvorrichtung (5) von aussen her spätestens dann verunmöglicht, wenn die Leiterelemente (51) die Federkontaktklemmen (3) kontaktieren, bevorzugt bereits vorher.

## Claims

1. An electrical spring contact clamp (3) for a meter plug-in clamp which is used to connect an electricity meter to the electrical power supply network, the spring contact clamp (3) comprising
a contact tulip (31) with a first clamping leg (32) and a second clamping leg (32), which are connected to one another via a connecting section (34) and are used for contacting and clamping a contact pin of the electricity meter on both sides; and
a contact tab (37) integrally connected to the contact tulip (31) for making contact with the electrical power supply network;
wherein the spring contact clamp (3) also comprises a first transfer section (36), which electrically and mechanically connects the first clamping leg (32) to the contact tab (37) at a distance from the connecting section (34),
**characterized in that**
spring contact clamp (3) comprises a second transfer section (36), which electrically and mechanically connects the second clamping leg (32) to the contact tab (37) at a distance from the connecting section (34).

2. The spring contact clamp (3) according to claim 1, wherein the first clamping leg (32) and the second clamping leg (32) each extend along a main direction away from the connecting section (34), which is perpendicular to a contacting surface formed by the contact tab (37).

3. The spring contact clamp (3) according to claim 1 or 2, wherein the spring contact clamp (3) is formed as a whole in one piece.

4. The spring contact clamp (3) according to any one of the preceding claims, wherein the contact tab (37) has a thickness twice as large as that of the first and second clamping legs (32).

5. The spring contact clamp (3) according to any one of the preceding claims, wherein the spring contact clamp (3) as a whole is made of a sheet metal.

6. The spring contact clamp (3) according to any one of the preceding claims, wherein the contact tab (37) is doubled by means of two superimposed sheet metal sections.

7. The spring contact clamp (3) according to claim 6, wherein the two sheet metal sections are connected to one another in a particularly oval clinching point (38).

8. A meter plug-in clamp for connecting an electricity meter to the electrical power supply network, comprising at least one spring contact clamp (3) according to any one of the preceding claims.

9. The meter plug-in clamp according to claim 8, comprising a housing (1) with bridging openings (12), which each serve to insert a conductor element (51) of a bypass device (5), the bridging openings (12) being arranged inside a recess (11) provided on the housing (1), which prevents contact with the conductor elements (51) of the bypass device (5) from the outside at the latest when the conductor elements (51) contact the spring contact clamps (3), preferably even before.

## Revendications

1. Borne de contact électrique à ressort (3) pour une borne enfichable de compteur, qui est utilisée pour connecter un compteur électrique au réseau d'alimentation électrique, comportant la borne de contact à ressort (3),
une tulipe de contact (31) dotée d'une première patte de serrage (32) et d'une seconde patte de serrage (32), qui sont reliées l'une à l'autre par l'intermédiaire d'une section de connexion (34) et sont utilisées pour mettre en contact et serrer une broche de contact du compteur électrique des deux côtés ; ainsi que
une languette de contact (37) reliée d'une seule pièce à la tulipe de contact (31) pour établir un contact avec le réseau d'alimentation électrique ;
dans laquelle la borne de contact à ressort (3) comporte également une première section de transfert (36), qui relie électriquement et mécaniquement la première patte de serrage (32) à la languette de contact (37) à distance de la section de connexion (34),
**caractérisée en ce que**
la borne de contact à ressort (3) comporte une seconde section de transfert (36), qui relie électriquement et mécaniquement la seconde patte de serrage (32) à la languette de contact (37) à distance de la section de connexion (34).

2. Borne de contact à ressort (3) selon la revendication 1, dans laquelle la première patte de serrage (32) et la seconde patte de serrage (32) s'étendent chacune le long d'une direction principale s'éloignant de la section de connexion (34), qui est perpendiculaire à une surface de contact formée par la languette de contact (37).

3. Borne de contact à ressort (3) selon la revendication 1 ou 2, dans laquelle la borne de contact à ressort (3) est formée d'une seule pièce dans son ensemble.

4. Borne de contact à ressort (3) selon l'une des revendications précédentes, dans laquelle la languette de contact (37) a une épaisseur deux fois supérieure à celle des première et deuxième pattes de serrage (32).

5. Borne de contact à ressort (3) selon l'une des revendications précédentes, dans laquelle la borne de contact à ressort (3) est réalisée dans son ensemble à partir d'une tôle.

6. Borne de contact à ressort (3) selon l'une des revendications précédentes, dans laquelle la languette de contact (37) est réalisée en deux parties au moyen de deux sections en tôle superposées.

7. Borne de contact à ressort (3) selon la revendication 6, dans laquelle les deux sections en tôle sont reliées l'une à l'autre dans un point de pénétration (38) particulièrement de forme ovale.

8. Borne enfichable de compteur pour connecter un compteur électrique au réseau d'alimentation électrique, comportant au moins une borne de contact à ressort (3) selon l'une des revendications précédentes.

9. Borne enfichable de compteur selon la revendication 8, comprenant un boîtier (1) avec des ouvertures de pontage (12), dont chacune sert à insérer un élément conducteur (51) d'un dispositif de pontage (5), les ouvertures de pontage (12) étant situées à l'intérieur d'un évidement (11) prévu sur le boîtier (1), ce qui rend impossible un contact avec les éléments conducteurs (51) du dispositif de pontage (5) depuis l'extérieur, au plus tard lorsque les éléments conducteurs (51) contactent les bornes à ressort (3), de préférence au préalable.
